# EUROPÄISCHE PATENTSCHRIFT

(11) **EP 3 931 524 B1**
(45) Veröffentlichungstag und Bekanntmachung des Hinweises auf die Patenterteilung: **06.11.2024**
(21) Anmeldenummer: 20707241.4
(22) Anmeldetag: 25.02.2020
(51) Int. Cl.: G01B 11/00, G06T 7/55, G01S 19/48, G01B 21/04, G01S 5/16, G01S 19/14, G06T 7/73

(54) **AUFBAU VON SCHALUNGEN UND GERÜSTEN MIT HILFE VON MOBILGERÄTEN**
CONSTRUCTION OF FORMWORK AND SCAFFOLDING USING MOBILE DEVICES
ÉDIFICATION DE COFFRAGES ET D'ÉCHAFAUDAGES À L'AIDE D'APPAREILS MOBILES

(30) Priorität: 27.02.2019 DE 102019105015
(43) Veröffentlichungstag der Anmeldung: 05.01.2022
(73) Patentinhaber: Peri AG, 89264 Weißenhorn (DE)
(72) Erfinder: PEPER, Sven Michael, 89264 Weißenhorn (DE); LÓPEZ BUITRAGO, Miguel Angel, 89264 Weißenhorn (DE); LÓPEZ BUITRAGO, Pablo, 89264 Weißenhorn (DE)
(74) Vertreter: Müller Schupfner & Partner Patent- und Rechtsanwaltspartnerschaft mbB (Muc)
(86) Internationale Anmeldenummer: PCT/EP2020/054872
(87) Internationale Veröffentlichungsnummer: WO 2020/173924

(56) Entgegenhaltungen:
- WO-A1-2015/071940
- US-A1- 2015 310 135
- US-A1- 2017 256 097
- US-B1- 9 918 204

## Beschreibung

Die vorliegende Anmeldung beansprucht die Priorität der deutschen

Patentanmeldung Nr. 10 2019 105 015.4, eingereicht am 27. Februar 2019.

Die Erfindung betrifft computerimplementierte Unterstützung beim Aufbau und bei der Kontrolle von Schalungen und Gerüsten auf Baustellen.

### Stand der Technik

Wenn ein Bauwerk durch Betonieren hergestellt wird, wird in der Regel eine Schalung als Gussform für den Frischbeton eingesetzt. Um eine Schalung schnell herstellen zu können und das Material vielfach wiederverwenden zu können, werden Schalungssysteme aus vorgefertigten Standardelementen eingesetzt. Ein beispielhaftes solches Schalungssystem ist aus der WO 2005/040 525 A1 bekannt. Ebenso werden auch Gerüste aus vorgefertigten Standardelementen aufgebaut.

Mit der zunehmenden Professionalisierung des Schalungs- und Gerüstmarktes hat auch die Komplexität von Schalungen und Gerüsten immer weiter zugenommen. Es kommen vielfach auf Effizienz getrimmte, in CAD-Programmen vorgeplante Lösungen zum Einsatz. Dass eine derartige Lösung die gewünschte technische Wirkung in Bezug auf Materialverbrauch, Standsicherheit oder andere bei der

Planung berücksichtigte Kriterien erzielt, setzt voraus, dass die Planung beim physischen Aufbau auf der Baustelle genau befolgt wird. Dies ist dem Personal auf der Baustelle häufig nicht bewusst, so dass es in der Praxis zu Abweichungen von der Planung kommt, die damit ad absurdum geführt wird. Eine Unterstützung beim Aufbau durch Vertreter der Bauzulieferer, die über das nötige Wissen verfügen, kann derartige Fehler vermeiden, ist jedoch vergleichsweise teuer.

US 9 918 204 B1 offenbart ein Verfahren zur Lokalisierung eines Mobilgeräts innerhalb eines Gebäudes. Nach einer ersten groben Abschätzung, in welchem Raum sich das Mobilgerät befindet, wird eine Punktwolke der Umgebung des Mobilgeräts aufgenommen und mit einer zuvor im Gebäude aufgenommenen Referenz-Punktwolke verglichen. Aus dem Ergebnis dieses Vergleichs werden die Position und die Orientierung des Mobilgeräts ausgewertet.

US 2015/310 135 A1 offenbart ein Verfahren zur Projektion von Informationen aus einem Building Information Model, BIM, in Fotos einer Baustelle, um so zu einem dreidimensionalen Punktwolkenmodell der Baustelle zu gelangen und den Baufortschritt zu visualisieren.

WO 2015/071 940 A1 offenbart ein mobiles Gerät, das mit einer Kamera einen Bauplatz fotografiert und ein als dreidimensionales Modell vorliegendes zu errichtendes Gebäude als Augmented Reality an der richtigen Stelle in das Bild des Bauplatzes einblendet.

US 2017/256 097 A1 offenbart ein System zur genauen Lokalisierung eines Mobilgeräts mit Hilfe von Funkbaken für den Zweck, Augmented Reality-Inhalte möglichst genau in Bilder der Umgebung des Mobilgeräts einblenden zu können.

### Aufgabe und Lösung

Es ist daher die Aufgabe der Erfindung, Mobilgeräte für eine Computerunterstützung beim Aufbau von Schalungen und/oder Gerüsten auf Baustellen nutzbar zu machen.

Diese Aufgabe wird erfindungsgemäß gelöst durch ein Verfahren zur Kalibrierung gemäß Hauptanspruch 1 sowie durch ein Verfahren zur computerunterstützten Qualitätskontrolle gemäß Nebenanspruch 13. Weiter vorteilhafte Ausgestaltungen ergeben sich aus den darauf rückbezogenen Unteransprüchen.

### Offenbarung der Erfindung

Die Erfindung wird durch die Patentansprüche definiert. Beispiele und Ausführungsformen, die nicht unter die Ansprüche fallen, werden präsentiert, um die beanspruchte Erfindung zu illustrieren und ihr Verständnis zu erleichtern.

Im Rahmen der Erfindung wurde ein Verfahren zur Kalibrierung eines internen Koordinatensystems eines Mobilgeräts gegen ein absolutes Koordinatensystem einer Baustelle entwickelt. Dieses absolute Koordinatensystem kann insbesondere ein Weltkoordinatensystem sein, das jedem Ort einen Breiten- und Längengrad auf der Erdoberfläche zuordnet. Es kann aber auch ausgehend von einem beliebigen anderen Fixpunkt aufgespannt sein und andere Koordinaten verwenden. Beispielsweise ist für die meisten Bauvorhaben die Erdkrümmung nicht relevant, so dass mit kartesischen Koordinaten gearbeitet werden kann.

Bei dem Verfahren wird an einer Mehrzahl von Positionen auf der Baustelle, sowie optional zusätzlich mit einer Mehrzahl von Orientierungen des Mobilgeräts, jeweils mit dem Mobilgerät mindestens ein Bild aufgenommen, das oder der mindestens einen Teil der Baustelle zeigt.

Das Bild wird erfindungsgemäß mit einer oder mehreren Kameras des Mobilgeräts aufgenommen. Beispielsweise kann mit einer einzelnen Kamera ein zweidimensionales Bild aufgenommen werden. Mit einer Kombination aus einer Kamera und einem Tiefensensor, oder beispielsweise auch mit einer stereoskopischen Anordnung von zwei oder mehr Kameras, kann ein dreidimensionales Bild aufgenommen werden. Mit einem Scanner, der beispielsweise einen Laserstrahl aussendet, kann ein Scan aufgenommen werden, der beispielsweise ausgehend vom Ort des Mobilgeräts für jede Raumrichtung die Entfernung bis zu dem Punkt angibt, an dem der Laserstrahl reflektiert wird.

Beispielsweise kann ein satellitengestütztes Positionierungssystem eine Position des Mobilgeräts in Weltkoordinaten angeben, die Bruchteile von Breitengraden und Längengraden umfassen. Das absolute Koordinatensystem der Baustelle kann beispielsweise ein kartesisches Koordinatensystem sein, wobei die Weltkoordinaten mindestens eines Fixpunktes dieses Koordinatensystems bekannt sind.

Bei jeder Aufnahme wird zusätzlich die Position sowie optional zusätzlich die Orientierung des Mobilgeräts in dem internen Koordinatensystem des Mobilgeräts sensorisch erfasst. Hierfür können beispielsweise Beschleunigungssensoren, Trägheitssensoren, Neigungssensoren, Drehratensensoren und/oder Gyroskope verwendet werden. Beispielsweise können lineare Beschleunigungen und/oder Winkelbeschleunigungen doppelt aufintegriert werden, um die Position des Mobilgeräts ausgehend von einer zuletzt bekannten Position fortzuschreiben.

Es werden Gleichungen aufgestellt mit Unbekannten, die die gesuchte Transformation zwischen dem internen Koordinatensystem des Mobilgeräts und dem absoluten Koordinatensystem der Baustelle charakterisieren. Die Unbekannten werden als Lösungen eines aus den aufgestellten Gleichungen gebildeten Gleichungssystems ermittelt, so dass die gesuchte Transformation erhalten wird.

Dabei können die Gleichungen auf zwei verschiedene Weisen erhalten werden.

Zum einen kann erfindungsgemäß mindestens ein geometrisches Merkmal mit bekannter Position im absoluten Koordinatensystem der Baustelle in einem Bild, und/oder in einem aus mehreren Bildern ermittelten dreidimensionalen Ist-Modell der Baustelle, erkannt werden. In Verbindung mit der sensorisch erfassten Position und Orientierung des Mobilgeräts in dem internen Koordinatensystem des Mobilgeräts entsteht hieraus eine Gleichung, deren Lösungen diejenigen Transformationen zwischen dem internen Koordinatensystem des Mobilgeräts und dem absoluten Koordinatensystem der Baustelle charakterisieren, bei denen
- die sensorisch erfasste Position und Orientierung des Mobilgeräts in seinem internen Koordinatensystem,
- die Form, Orientierung und Position des geometrischen Merkmals in dem Bild und
- die bekannte Position des geometrischen Merkmals in dem absoluten Koordinatensystem der Baustelle
miteinander möglichst widerspruchsfrei im Einklang stehen. Beispielsweise lassen sich aus der bekannten Position des geometrischen Merkmals im absoluten Koordinatensystem in Verbindung mit der Transformation dieser Position in das interne Koordinatensystem des Mobilgeräts und der Position des Mobilgeräts in diesem internen Koordinatensystem die Form, Orientierung und Position des geometrischen Merkmals im Bild und/oder Scan vorhersagen. Wenn die

Transformation korrekt ist, dann sollte das geometrische Merkmal genau wie vorhergesagt im Bild erscheinen.

Zum anderen kann (nicht erfindungsgemäß) die mit dem Positionierungssystem bestimmte Position zu der sensorisch in dem internen Koordinatensystem des Mobilgeräts bestimmten Position in Beziehung gesetzt werden. Hierbei wird eine Gleichung erhalten, deren Lösungen diejenigen Transformationen repräsentieren, mit denen sich Koordinaten der mit dem Positionierungssystem bestimmten Position im absoluten Koordinatensystem der Baustelle möglichst widerspruchsfrei auf die sensorisch bestimmte Position im internen Koordinatensystem des Mobilgeräts abbilden lassen.

Jede einzelne dieser Gleichungen hat üblicherweise mehrere Lösungen, so dass mehrere Gleichungen notwendig sind, um die gesuchte Transformation eindeutig festzulegen. Umgekehrt wird eine Lösung eines aus mehreren Gleichungen bestehenden Gleichungssystems in aller Regel nicht alle Gleichungen exakt erfüllen können, sondern jede Gleichung nur bis auf einen bestimmten Fehler erfüllen, wobei dann beispielsweise der mittlere quadratische Fehler über alle Gleichungen minimiert werden kann. Ursache hierfür ist, dass die physikalischen Messungen, die in die Gleichungen eingehen, mit unvermeidbaren Unsicherheiten behaftet sind.

In dem Gleichungssystem können insbesondere Gleichungen, die auf dem Wiedererkennen geometrischer Merkmale in Bildern und/oder Scans basieren, und Gleichungen, die auf dem direkten Vergleich von auf verschiedenen Wegen ermittelten Koordinaten basieren, miteinander in beliebiger Weise kombiniert sein.

Es wurde erkannt, dass es durch das Lösen des beschriebenen Gleichungssystems eine Transformation zwischen dem internen Koordinatensystem des Mobilgeräts und dem absoluten Koordinatensystem der Baustelle ermittelt werden kann, die der Wirklichkeit bis auf eine Genauigkeit von wenigen Millimetern oder besser nahekommt. Der Schlüssel hierzu ist die große Flexibilität bei der Art und Anzahl der in Form von Gleichungen zusammengeführten Informationen.

Typischerweise herrschen auf verschiedenen Baustellen verschiedene Gegebenheiten, was die Verfügbarkeit von Informationen angeht. So kann beispielsweise bei einer Baustelle im Freien eine freie Sicht zu den Satelliten eines Navigationssystems bestehen, was die Lokalisierung einzelner Punkte in Weltkoordinaten mit einer Genauigkeit bis hinab zu wenigen Zentimetern ermöglicht. Auf einer Baustelle in einer überdachten Halle hingegen kann die satellitengestützte Navigation nur eingeschränkt oder gar nicht verfügbar sein, während die fehlenden Witterungseinflüsse zugleich eine bessere Wiedererkennung geometrischer Merkmale in Bildern ermöglichen. Mit dem Gleichungssystem kann immer die Menge an Informationen, die physikalisch verfügbar ist, als gegeben hingenommen und optimal im Hinblick auf die gesuchte Transformation ausgewertet werden.

Die so erhaltene genaue Transformation zwischen den Koordinatensystemen wiederum ist der Türöffner für die Computerunterstützung bei der physischen Realisierung einer Schalung und/oder eines Gerüsts. Wie zuvor erläutert, werden komplexe Schalungen und Gerüste mit CAD-Programmen vorausgeplant. Das bedeutet, dass ein dreidimensionales Modell der Schalung, bzw. des Gerüsts, im absoluten Koordinatensystem der Baustelle verfügbar ist. Bilder oder Scans, die das Mobilgerät aufgenommen hat und mit denen die physische Realisierung der Schalung, bzw. des Gerüsts, erleichtert oder geprüft werden soll, liegen hingegen im internen Koordinatensystem des Mobilgeräts vor. Es wird also das Bild im absoluten Koordinatensystem der Baustelle, und/oder das dreidimensionale Modell im internen Koordinatensystem des Mobilgeräts, benötigt. Genau dies leistet die mit dem beschriebenen Verfahren ermittelte Transformation.

So kann dann beispielsweise das dreidimensionale Modell der Schalung, bzw. des Gerüsts, als "Augmented Reality" einer aktuellen Ansicht der Baustelle aus der Perspektive des Mobilgeräts überlagert werden, so dass diese Ansicht um die aufzubauende Schalung, bzw. um das aufzubauende Gerüst, ergänzt wird.

Beispielsweise kann auf einem Smartphone oder Tablet-PC als Mobilgerät eine perspektivisch korrekte zweidimensionale Projektion des dreidimensionalen Modells einem aktuell von einer Kamera des Mobilgeräts aufgenommenen zweidimensionalen Bild überlagert und auf einem Display angezeigt werden. Dabei kann vorteilhaft die Deckkraft dieser Projektion so gewählt sein, dass der Benutzer visuell erkennen kann, inwieweit der physische Aufbau der Schalung, bzw. des Gerüsts, mit dem Soll-Modell deckungsgleich ist. Gleiches ist auch mit eine Virtual Reality- oder Mixed Reality-Brille als Mobilgerät möglich, wobei dies den weiteren Vorteil bietet, dass der Benutzer unter dem Einsatz seiner beiden Hände jedes einzelne Teil genau an seinen gemäß Soll-Modell vorgesehenen Platz positionieren kann.

Beispielsweise kann eine solche Brille über eine oder mehrere auf die Baustelle gerichtete Kameras Bilder der Baustelle erfassen, und diese Bilder können auf ein Display im Inneren der Brille übertragen werden. Bei der Darstellung auf dem Display können die Bilder mit der zweidimensionalen Projektion des dreidimensionalen Modells überlagert werden. Dabei können die Bilder der Baustelle auch beispielsweise mit einem Weitwinkeleffekt aufbereitet werden, so dass die Anzeige auf dem Display ein größeres Sichtfeld abdeckt als vom menschlichen Auge normalerweise erfassbar ist.

Es kann auch beispielsweise eine Augmented Reality-Brille genutzt werden, die eine direkte optische Durchsicht auf die physische Szenerie ermöglicht, statt diese Szenerie mit einer Kamera aufzunehmen und das Bild auf einem Display anzuzeigen. Die Projektion des dreidimensionalen Modells kann dann beispielsweise teildurchlässig auf die direkte optische Durchsicht überlagert werden.

Durch den direkten visuellen Abgleich der physischen Szenerie auf der Baustelle sind Planabweichungen und Fehler beim Zusammensetzen der Schalung, bzw. des Gerüsts, direkt erkennbar und können rechtzeitig behoben werden. Dies ist insbesondere dann von Vorteil, wenn ein Gebäude oder Gebäudeteil nicht "in einem Guss" erstellt wird, sondern in mehreren Arbeitstakten: Die Genauigkeit, mit der die einzelnen Arbeitstakte nahtlos aneinander anschließen, wird dann vorteilhaft verbessert.

Zu den erkennbaren Fehlern können insbesondere auch solche Fehler gehören, die die Standsicherheit der Schalung bzw. des Gerüsts gefährden, wie beispielsweise vergessene, vertauschte oder falsch (etwa verkehrt herum) montierte Befestigungsmittel. Nicht alle diese Fehler lassen sich bereits beim Design der Standardelemente unterbinden, indem beispielsweise nur zueinander passende Teile in der richtigen Orientierung zusammenrasten.

Der durch "Augmented Reality" unterstützte Aufbau des Gerüsts, bzw. der Schalung, kann über die bloße Vermeidung von Planabweichungen und Fehlern hinaus generell die Genauigkeit bei der letztendlichen Errichtung des Gebäudes oder Gebäudeteils verbessern. Die Transformation zwischen den Koordinatensystemen kann durch sehr viele Gleichungen gestützt sein, so dass einzelne Messfehler bei der Aufnahme von Bildern, bei der sensorgestützten Positionsbestimmung und bei der Positionsbestimmung mit dem Positionierungssystem in der Masse der Informationen untergehen. Wird hingegen eine Schalung oder ein Gerüst konventionell geplant, wird der Aufbauplan häufig nur auf Grund weniger Messungen in der physischen Welt angezeichnet. Kleine Ungenauigkeiten in diesen Messungen oder im manuellen Anzeichnen schlagen dann ungehindert auf das Endergebnis durch.

Alternativ oder auch in Kombination zur Darstellung des Soll-Modells als "Augmented Reality" kann auch ein automatisierter Vergleich zwischen dem Soll-Modell der Schalung und mindestens einem von einer Kamera des Mobilgeräts aufgenommenen Bild und/oder Scan vorgenommen werden. Anhand dieses Vergleichs kann geprüft werden, ob mindestens ein Bauelement und/oder Zubehörteil der Schalung auf der Baustelle korrekt verbaut worden ist.

Hierbei ist es freigestellt, ob der Vergleich im internen Koordinatensystem des Mobilgeräts erfolgt oder im absoluten Koordinatensystem der Baustelle. Wenn der Vergleich im internen Koordinatensystem des Mobilgeräts durchgeführt wird, kann beispielsweise eine perspektivisch korrekte zweidimensionale Projektion des dreidimensionalen Modells erstellt und mit dem von der Kamera des Mobilgeräts aufgenommenen Bild verglichen werden. Es kann aber auch beispielsweise lediglich geprüft werden, ob das Bild im Einklang mit der Hypothese steht, dass das Bauelement und/oder Zubehörteil korrekt verbaut worden ist.

Das geometrische Merkmal, das für die Erstellung einer oder mehrerer Gleichungen genutzt wird, kann insbesondere beispielsweise ein zwei-oder dreidimensionaler, auf der Baustelle angebrachter Markierungscode sein. Die Positionen derartiger Markierungscodes können im absoluten Koordinatensystem der Baustelle genau vermessen bzw. festgelegt werden.

In einer weiteren vorteilhaften Ausgestaltung wird mindestens ein Bauelement und/oder Zubehörteil als geometrisches Merkmal gewählt. Beispielsweise können aus einem Gebäudemodell einer industriellen Anlage die Positionen deutlich erkennbarer Rohre oder anderer Anlagenteile entnommen werden.

In einer weiteren besonders vorteilhaften Ausgestaltung beinhaltet das Erkennen des geometrischen Merkmals, aus der Verzerrung des geometrischen Merkmals in dem Bild und/oder Scan eine Raumrichtung des Mobilgeräts zu dem geometrischen Merkmal zum Zeitpunkt der Aufnahme zu ermitteln. Alternativ oder in Kombination hierzu kann aus der Größe des geometrischen Merkmals in dem Bild eine Entfernung des Mobilgeräts zu dem geometrischen Merkmal zum Zeitpunkt der Aufnahme ermittelt werden.

Auf diese Weise kann die Information, welche geometrischen Merkmale sich an welchen bekannten Positionen befinden, optimal ausgenutzt werden. Insbesondere kann beispielsweise ein und dasselbe geometrische Merkmal, dessen Position und Orientierung im absoluten Koordinatensystem der Baustelle einmal eingemessen wurden, durch Aufnahme von Bildern aus mehreren Entfernungen und Perspektiven mehrfach für die Kalibrierung genutzt werden.

Weiterhin können auch aus ein und demselben Bild Informationen über mehrere in diesem Bild erkennbare geometrische Merkmale extrahiert werden. Diese Informationen sind dann mit der gleichen sensorisch bestimmten Position des Mobilgeräts im internen Koordinatensystem des Mobilgeräts verknüpft.

In einer weiteren besonders vorteilhaften Ausgestaltung werden den Gleichungen in dem Gleichungssystem in Abhängigkeit der Verlässlichkeit der in ihnen enthaltenen Informationen unterschiedliche Gewichte zugewiesen. Auf diese Weise kann dem Umstand Rechnung getragen werden, dass nicht alle der vielen möglichen Informationsquellen die gleiche Genauigkeit liefern können. Informationen mit einer geringeren Verlässlichkeit müssen nicht zwangsläufig verworfen werden, sondern können auch zur Kalibrierung beitragen, während gleichzeitig gewährleistet ist, dass besonders präzise Informationen nicht verwässert werden.

In einer weiteren besonders vorteilhaften Ausgestaltung wird das Gleichungssystem ausgehend von Startwerten, die aus a-priori-Informationen über die Baustelle gewonnen wurden, iterativ gelöst. Auf diese Weise konvergiert die Lösung schneller, und die Wahrscheinlichkeit, dass sie an einem Nebenoptimum "festhängt", wird vermindert.

In einer weiteren besonders vorteilhaften Ausgestaltung beinhaltet das Erkennen des geometrischen Merkmals, mindestens eine Oberfläche, und/oder mindestens einen Punkt, in dem Bild und/oder Scan zu erkennen und mindestens einer Oberfläche, beziehungsweise mindestens einem Punkt, des geometrischen Merkmals zuzuordnen.

Für die Erkennung von Oberflächen als solche sind bereits ausgereifte Lösungen verfügbar, so dass nur noch in die Zuordnung zu der Oberfläche des geometrischen Merkmals Aufwand investiert werden muss. Beispielsweise kann die Zuordnung vom Bediener des Mobilgeräts angefordert werden.

Als Punkte können beispielsweise markante Punkte von geometrischen Merkmalen verwendet werden, wie beispielsweise Eckpunkte oder auch Schnittpunkte mehrerer geometrischer Merkmale.

In einer weiteren besonders vorteilhaften Ausgestaltung wird mindestens ein geometrisches Merkmal gewählt, dessen Position im absoluten Koordinatensystem der Baustelle aus einem vorgegebenen dreidimensionalen Soll-Modell der Baustelle, und/oder eines zu errichtenden oder zu ändernden Bauwerks, hervorgeht. Dann kann die Kalibrierung in noch höherem Maße automatisiert werden, da kein manuelles Einmessen von Position und Orientierung des geometrischen Merkmals erforderlich ist. Insbesondere können wesentlich mehr geometrische Merkmale analysiert und entsprechend mehr Gleichungen aufgestellt werden, um die Genauigkeit der letztendlich erhaltenen Kalibrierung zu erhöhen.

Dabei kann beispielsweise mindestens eine Zuordnung eines im Bild und/oder Scan abgebildeten geometrischen Merkmals zu einem in dem dreidimensionalen Soll-Modell der Baustelle enthaltenen geometrischen Merkmal von einem Bediener angefordert werden. Wenn die automatische Zuordnung nicht zweifelsfrei möglich ist, dann ist ein solcher Beitrag des Bedieners eine sinnvolle Ergänzung. Menschen haben tendenziell gute Fähigkeiten, derartige Zuordnungen zu treffen, und anders als beim manuellen Einmessen von Position und Orientierung eines geometrischen Merkmals ist hier keine Verschlechterung der Genauigkeit zu befürchten.

Wie zuvor erläutert, können geometrische Merkmale nicht nur in Bildern und/oder Scans wiedererkannt werden, sondern alternativ oder auch in Kombination hierzu auch in einem dreidimensionalen Ist-Modell der Baustelle, das aus mehreren Bildern ermittelt wurde. Indem ein solches dreidimensionales Ist-Modell die Information aus mehreren Bildern und/oder Scans aggregiert, kann der Einfluss von Ungenauigkeiten, die bei der Aufnahme einzelner Bilder unter anderem durch die begrenzte Pixelauflösung der verwendeten Kamera entstehen, zurückgedrängt werden.

Das Erzeugen eines dreidimensionalen Ist-Modells der Baustelle aus mehreren Bildern beinhaltet in einer weiteren besonders vorteilhaften Ausgestaltung, dreidimensionale Muster und Formen, und/oder zweidimensionale Projektionen hiervon, in den Bildern zu erkennen. So kann beispielsweise aus der Verzerrung und der Größe des Musters, bzw. der Form, die Entfernung zu dem Ort, an dem die Form, bzw. das Muster, sich befindet, und die Perspektive, unter der die Form, bzw. das Muster, in dem Bild sichtbar ist, ermittelt werden. Mit dieser Information kann das Muster, bzw. die Form, im dreidimensionalen Ist-Modell korrekt platziert werden.

Alternativ oder auch in Kombination hierzu können die Pixel der Bilder zu einer Punktwolke im dreidimensionalen Raum aggregiert werden, beispielsweise mit den Methoden der Photogrammetrie. Die dreidimensionalen Muster bzw. Formen können dann in dieser Punktwolke erkannt werden.

Beispielsweise kann ein Live-Datenstrom des Kamerabildes des Mobilgeräts an einen externen Server gestreamt werden, wo das Live-Kamerabild in einzelne Pixel zerteilt wird. Aus der Zusammensetzung der einzelnen Pixel können dann, beispielsweise mit maschinellem Lernen, Muster und Formen, bzw. zweidimensionale Projektionen hiervon, erkannt werden. Die Analyse der Zusammensetzung kann sich beispielsweise auf die Abstände der Pixel zueinander, die Farbinformationen der einzelnen Pixel, und/oder auf die Häufung oder Gruppierung von Pixeln ähnlicher Farbinformation und die Form dieser Gruppierung, beziehen. Die fortlaufende Analyse der mit der Live-Übertragung übermittelten Daten kann dann auf das dreidimensionale Ist-Modell der Umgebung des Mobilgeräts führen, das aus Punkten im dreidimensionalen Raum zusammengesetzt ist, welche eine Punktwolke bilden. Dieses Ist-Modell kann dann, beispielsweise in Bezug auf die extrahierten Farbinformationen und Muster, mit einem dreidimensionalen Gebäudemodell verglichen werden.

Hierbei bilden Farbinformationen und extrahierte Muster zwei Informationslayer, anhand welcher der Vergleich durchgeführt werden kann, wobei der Hauptanteil der Information in den extrahierten Mustern, also in den Forminformationen, steckt. Anhand der Farbinformationen kann vorgefiltert werden, welche Elemente des Gebäudemodells in den Vergleich der Forminformationen eingehen. Wenn, gegebenenfalls nach Skalieren, Drehen, Verschieben oder anderen Operationen, mindestens ein vorgegebener Prozentsatz der Punkte der Punktwolke auf Teile des dreidimensionalen Gebäudemodells passt, dann bedeutet dies, dass die geometrischen Merkmale im dreidimensionalen Gebäudemodell in dem dreidimensionalen Ist-Modell erkannt wurden. Aus den bei der Bildaufnahme sensorisch erfassten Positionen und Orientierungen des Mobilgeräts in Verbindung mit den Operationen, die nötig waren, um das Ist-Modell mit dem dreidimensionalen Gebäudemodell in den vorgegebenen Grad der Übereinstimmung zu bringen, ergeben sich eine oder mehrere Gleichungen für die gesuchte Transformation zwischen dem internen Koordinatensystem des Mobilgeräts und dem absoluten Koordinatensystem der Baustelle.

Je höher der Grad der Übereinstimmung zwischen dem dreidimensionalen Ist-Modell und dem dreidimensionalen Gebäudemodell ist, desto mehr ist der Lösungsraum der aus dem Vergleich folgenden Gleichungen eingeschränkt. Eine sehr gute Übereinstimmung der aus dem Strom zweidimensionaler Bilder extrahierten dreidimensionalen Punktwolke mit dem dreidimensionalen Gebäudemodell kann die gesuchte Transformation zwischen dem internen Koordinatensystem und dem absoluten Koordinatensystem eindeutig, oder fast eindeutig, festlegen. Ist die Übereinstimmung hingegen weniger gut, können die aus dem Vergleich der Punktwolke mit dem Gebäudemodell folgenden Gleichungen noch mit weiteren Gleichungen ergänzt werden. Beispielsweise können Gleichungen, die aus dem Vergleich einer mit einem Positionierungssystem bestimmten Position im absoluten Koordinatensystem der Baustelle mit einer sensorisch bestimmten Position im internen Koordinatensystem des Mobilgeräts gewonnen wurden, herangezogen werden. Auch die direkte Wiedererkennung geometrischer Merkmale in den zweidimensionalen Bildern kann zur Gewinnung weiterer Gleichungen herangezogen werden.

In einer weiteren besonders vorteilhaften Ausgestaltung werden Bildpixel, deren Farbinformationen ähnlich sind, als zum gleichen dreidimensionalen Muster, bzw. zur gleichen dreidimensionalen Form, und/oder zum gleichen Punkt im dreidimensionalen Raum, gehörig gewertet. Hierhinter steckt die Erkenntnis, dass speziell viele Objekte auf Baustellen (wie etwa Bauelemente oder Zubehörteile) vergleichsweise wenige farbige Features aufweisen.

Dementsprechend können auch in einer weiteren vorteilhaften Ausgestaltung geometrische Merkmale, die in dem dreidimensionalen Ist-Modell erkannt werden, anhand der Farbinformationen der Pixel in Bildern vorausgewählt werden.

Nach dem zuvor Beschriebenen bezieht sich die Erfindung auch auf ein Verfahren zur computerunterstützten Qualitätskontrolle einer vorgegebenen Schalung, und/oder eines vorgegebenen Gerüsts, auf einer Baustelle. Hierbei wird zunächst mit dem zuvor beschriebenen Verfahren ein internes Koordinatensystem eines Mobilgeräts auf ein absolutes Koordinatensystem der Baustelle kalibriert.

Auf der Basis dieser Kalibrierung kann ein im absoluten Koordinatensystem der Baustelle erstelltes dreidimensionales Soll-Modell der Schalung, bzw. des Gerüsts, und/oder mindestens eine im absoluten Koordinatensystem der Baustelle erfasste räumlich aufgelöste Zustandsgröße der Schalung, bzw. des Gerüsts, in das interne Koordinatensystem des Mobilgeräts transformiert werden. Das Soll-Modell, und/oder die Zustandsgröße, der Schalung, bzw. des Gerüsts, kann dann mit einer aktuellen Ansicht der Baustelle aus der Perspektive des Mobilgeräts überlagert werden. Wie zuvor beschrieben, kann diese Überlagerung aus einem vom Mobilgerät aufgenommenen Kamerabild angefertigt werden und auf einem Display des Mobilgeräts angezeigt werden. Die Überlagerung kann aber auch beispielsweise teildurchlässig auf eine direkte optische Durchsicht zur physischen Szenerie erfolgen. Hiermit lässt sich visuell überprüfen, ob der tatsächliche physische Aufbau der Schalung, bzw. des Gerüsts, dem dreidimensionalen Soll-Modell entspricht.

Alternativ oder auch in Kombination hierzu kann anhand eines Vergleichs zwischen dem Soll-Modell der Schalung, bzw. des Gerüsts, einerseits und mindestens einem von dem Mobilgerät aufgenommenen Bild, und/oder mindestens einem aus mehreren solchen Bildern ermittelten Ist-Modell der Baustelle, andererseits geprüft werden, ob mindestens ein Bauelement und/oder Zubehörteil der Schalung, bzw. des Gerüsts, auf der Baustelle korrekt verbaut worden ist. Diese Prüfung kann vollautomatisch erfolgen und erfordert nicht einmal eine Bildausgabe an den Benutzer des Mobilgeräts.

Bei der Zustandsgröße kann es sich insbesondere um eine solche Größe handeln, die im Hinblick auf die Qualität und/oder Sicherheit der Schalung, bzw. des Gerüsts, zwar wichtig, jedoch für einen Menschen ohne technische Hilfsmittel in der physischen Welt nicht erfassbar ist. Ein Beispiel hierfür ist eine mechanische Belastung, der die Schalung, das Gerüst oder ein Teil hiervon ausgesetzt sind.

Beispielsweise wird eine mit Beton gefüllte Schalung durch den Schweredruck des Betons von innen mit einem Druck belastet. Gerüstteile können beispielsweise mit einer Druckkraft, mit einer Zugkraft und/oder mit einem Drehmoment belastet werden.

Die Zustandsgröße kann beispielsweise Ausgabedaten mindestens eines Sensors umfassen, der zur direkten oder indirekten Messung der Zustandsgröße an einem oder mehreren Orten der Schalung, bzw. des Gerüsts, ausgebildet ist. Beispielsweise können an der Schalung, bzw. am Gerüst, Dehnungsmessstreifen oder andere Sensoren für die Belastung angebracht sein. Die Zustandsgröße kann aber auch beispielsweise auf einem externen Server errechnet werden. Beispielsweise ist bei gegebener Innengeometrie der Schalung und gegebener eingefüllter Betonmenge der auf jedem Punkt der Schalung lastende Schweredruck bekannt.

Indem eine mechanische Belastung visualisiert wird, können insbesondere beispielsweise Aufbaufehler erkannt werden, die dazu führen, dass die Schalung, bzw. das Gerüst, ungleichmäßig belastet und/oder in Teilbereichen überlastet wird. So kann beispielsweise ein fehlendes Bauteil an einer Stelle zur Folge haben, dass Bauteile an einer anderen Stelle dieses fehlende Bauteil kompensieren müssen und entsprechend stärker belastet werden. Dies kann zu einem schlagartigen Versagen von Bauteilen mit entsprechender Unfallgefahr führen.

Ein Bauteil muss nicht einmal komplett fehlen, um derartige Folgen herbeizuführen. Eine falsche Montage des Bauteils kann bereits genügen. Sind etwa vier Stützen, auf denen ein Gerüst steht, ungleichmäßig lang oder falsch auf die Unebenheiten des Bodens justiert, so kann dies dazu führen, dass das Gewicht des Gerüsts nur von drei statt von vier Stützen getragen wird. Optisch ist es nicht zu erkennen, dass die vierte Stütze nur lose auf dem Boden aufliegt und keine Kraft auf den Boden überträgt.

Das Verfahren kann zumindest teilweise von einem oder mehreren Computern oder Mobilgeräten durchgeführt werden und somit insbesondere in einer Software implementiert sein. Daher bezieht sich die Erfindung auch auf ein Computerprogramm mit maschinenlesbaren Anweisungen, die, wenn sie auf mindestens einem Computer, und/oder auf mindestens einem Mobilgerät, ausgeführt werden, den Computer, bzw. das Mobilgerät, dazu veranlassen, eines der beschriebenen Verfahren auszuführen. Ebenso bezieht sich die Erfindung auch auf einen maschinenlesbaren Datenträger, und/oder auf ein Downloadprodukt, mit dem Computerprogramm.

### Spezieller Beschreibungsteil

Nachfolgend wird der Gegenstand der Erfindung anhand von Figuren erläutert, ohne dass der Gegenstand der Erfindung hierdurch beschränkt wird. Es ist gezeigt:
Figur 1: Ablaufdiagramm eines Ausführungsbeispiels des Verfahrens 100;
Figur 2: Beispielhafte Gewinnung von Gleichungen 51-53 durch Erkennung 131 geometrischer Merkmale 22;
Figur 3: Beispielhafte Gewinnung von Gleichungen 54-56 durch Abgleich von durch ein Positionierungssystem bestimmten Positionen 4a-4c mit sensorisch ermittelten Positionen 12a-12c und/oder Orientierungen 13a-13c;
Figur 4: Beispielhafte Gewinnung von Gleichungen 51-56 mit Hilfe eines dreidimensionalen Ist-Modells 23 der Baustelle 2;
Figur 5: Ablaufdiagramm eines Ausführungsbeispiels des Verfahrens 200.

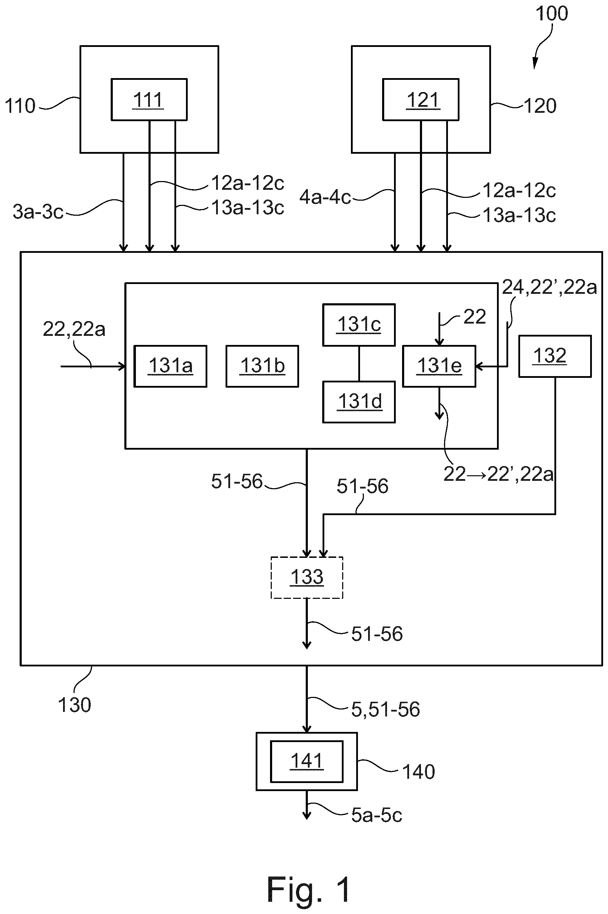

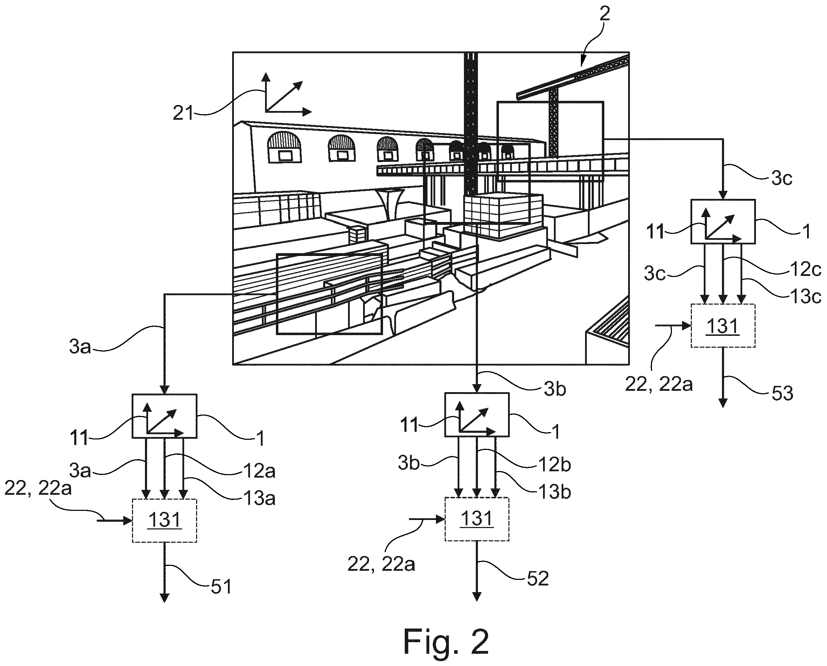

Figur 1 ist ein beispielhaftes Ablaufdiagramm eines Ausführungsbeispiels des Verfahrens 100. In Schritt 110 wird an einer Mehrzahl von Positionen auf der Baustelle 2, sowie optional zusätzlich mit einer Mehrzahl von Orientierungen des Mobilgeräts 1, jeweils mindestens ein Bild Scan 3a-3c aufgenommen, das mindestens einen Teil der Baustelle 2 zeigt. Der Benutzer des Mobilgeräts 1 kann also beispielsweise mit dem Mobilgerät über die Baustelle 2 gehen sowie optional zusätzlich auch an einer festen Position stehen und sich um seine eigene Achse drehen. Zusätzlich wird bei jeder Aufnahme 110 gemäß Block 111 auch die Position 12a-12c sowie optional zusätzlich Orientierung 13a-13c des Mobilgeräts 1 in dem internen Koordinatensystem 11 des Mobilgeräts 1 sensorisch erfasst. Die Datenaufnahme auf diese Weise ist in Figur 2 näher ausgeführt.

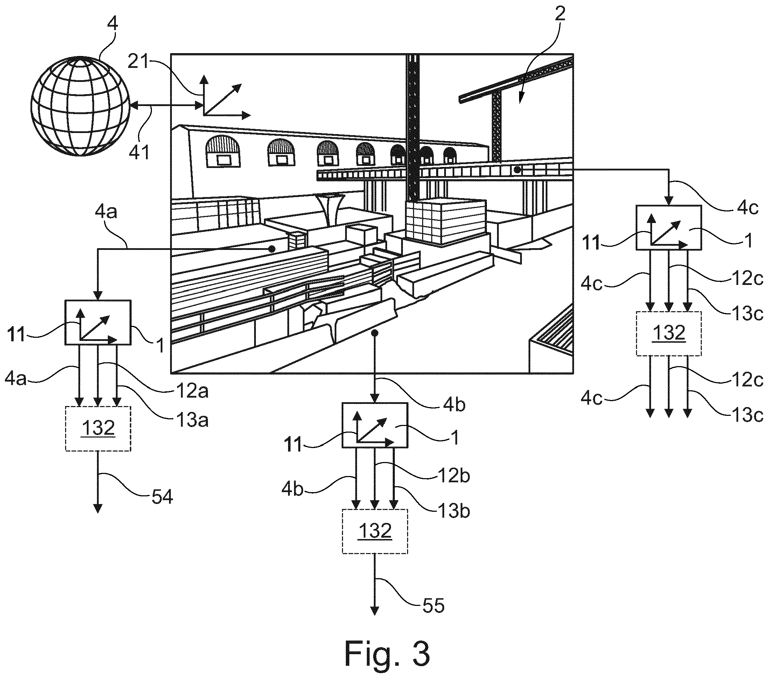

In Kombination hierzu kann in Schritt 120 an der Mehrzahl von Positionen, bzw. mit der Mehrzahl von Orientierungen des Mobilgeräts 1, jeweils die Position 4a-4c des Mobilgeräts 1 mit einem Positionierungssystem in einem Koordinatensystem 4, das in einer bekannten festen Relation 41 zum absoluten Koordinatensystem 21 der Baustelle 2 steht, bestimmt werden. Dabei wird, analog zu Block 111, gemäß Block 121 auch die Position 12a-12c und/oder Orientierung 13a-13c des Mobilgeräts 1 in dem internen Koordinatensystem 11 des Mobilgeräts 1 sensorisch erfasst. Die Datenaufnahme auf diese Weise ist in Figur 3 näher ausgeführt.

In Schritt 130 werden Gleichungen 51-56 in Unbekannten 5a-5c aufgestellt, die die gesuchte Transformation zwischen dem internen Koordinatensystem 11 des Mobilgeräts 1 und dem absoluten Koordinatensystem 21 der Baustelle 2 charakterisieren. Dies kann, einzeln oder in Kombination, auf zwei Weisen erfolgen. Gemäß Block 131 wird mindestens ein geometrisches Merkmal 22 mit bekannter Position 22a im absoluten Koordinatensystem 21 der Baustelle 2 in einem Bild 3a- 3c und/oder in einem aus mehreren solchen Bildern ermittelten dreidimensionalen Ist-Modell 23 der Baustelle 2, erkannt. Gemäß Block 132 wird die mit dem Positionierungssystem bestimmte Position 4a-4c zu der sensorisch in dem internen Koordinatensystem 11 des Mobilgeräts 1 bestimmten Position 12a-12c und/oder Orientierung 13a-13c in Beziehung gesetzt. Für die Erkennung 131 geometrischer Merkmale 22 gibt es wiederum mehrere beispielhafte Optionen, die innerhalb des Kastens 131 näher dargestellt sind und einzeln oder auch in Kombination genutzt werden können.

Gemäß Block 131a kann aus der Verzerrung des geometrischen Merkmals 22 in dem Bild 3a-3c eine Raumrichtung des Mobilgeräts 1 zu dem geometrischen Merkmal 22 zum Zeitpunkt der Bildaufnahme ermittelt werden. Das heißt, die Verzerrung liefert einen Hinweis auf die Perspektive, aus der das geometrische Merkmal 22 aufgenommen wurde, und diese Perspektive gibt wiederum die Raumrichtung an.

Gemäß Block 131b kann aus der Größe des geometrischen Merkmals 22 in dem Bild 3a-3c eine Entfernung des Mobilgeräts 1 zu dem geometrischen Merkmal 22 zum Zeitpunkt der Aufnahme ermittelt werden. Gemäß Block 131c kann mindestens eine Oberfläche, und/oder mindestens ein Punkt, erkannt werden, um diese Oberfläche, bzw. diesen Punkt, anschließend in Block 131d einer entsprechenden Oberfläche, bzw. einem entsprechenden Punkt, des geometrischen Merkmals 22 zuzuordnen.

Gemäß Block 131e kann mindestens eine Zuordnung eines im Bild 3a-3c abgebildeten geometrischen Merkmals 22 zu einem in einem dreidimensionalen Soll-Modell 24 der Baustelle 2 enthaltenen geometrischen Merkmal 22' von einem Bediener angefordert werden. Auf diese Weise kann die im Soll-Modell 24 abgelegte bekannte Position 22a des geometrischen Merkmals 22' dem abgebildeten geometrischen Merkmal 22a zugeordnet werden.

Optional können die Gleichungen 51-56 gemäß Block 133 in Abhängigkeit der Verlässlichkeit der jeweils in ihnen enthaltenen Informationen unterschiedlich gewichtet werden.

Die Gleichungen 51-56, auf welchem Wege auch immer gewonnen, bilden ein Gleichungssystem 5 in den Unbekannten 5a-5c. In Schritt 140 wird dieses Gleichungssystem 5 nach den Unbekannten 5a-5c gelöst, wobei gemäß Block 141 optional ein iterativer Weg beschritten werden kann ausgehend von Startwerten, die aus a-priori-Informationen über die Baustelle 2 gewonnen wurden. Die als Lösungen erhaltenen Werte der Unbekannten 5a-5c charakterisieren die gesuchte Transformation zwischen dem internen Koordinatensystem 11 des Mobilgeräts 1 und dem absoluten Koordinatensystem 21 der Baustelle 2.

Figur 2 zeigt ein Beispiel für die Gewinnung von Gleichungen 51-53 anhand zweidimensionaler Bilder 3a-3c, die verschiedene Ausschnitte ein und derselben Baustelle 2 zeigen. In diesem Beispiel, wie auch in Figur 3, wird lediglich vorausgesetzt, dass das Mobilgerät 1 zweidimensionale Bilder 3a-3c aufnehmen kann. Diese Fähigkeit ist den weitaus meisten Mobilgeräten "out of the box" gemein, während die Aufnahme dreidimensionaler Bilder oder Scans erweiterte Hardware oder Zusatzprogramme (Apps) benötigt.

Die Bilder 3a-3c leben jeweils im internen Koordinatensystem 11 des Mobilgeräts 1, und bei der Bildaufnahme werden die jeweilige Position 12a-12c, sowie optional zusätzlich die jeweilige Orientierung 13a-13c, des Mobilgeräts 1 sensorisch erfasst. In den Bildern 3a-3c werden gemäß Block 131 jeweils geometrische Merkmale 22 mit bekannter Position 22a im absoluten Koordinatensystem 21 der Baustelle 2 erkannt. Diese bekannte Position 22a ist mit der Tatsache, dass das geometrische Merkmal 22 im Bild 3a-3c erkannt wurde, in Verbindung mit der jeweiligen Position 12a-12c und/oder Orientierung 13a-13c des Mobilgeräts 1 nur für bestimmte Transformationen zwischen dem internen Koordinatensystem 11 des Mobilgeräts 1 und dem absoluten Koordinatensystem 21 der Baustelle 2 stimmig. So ist etwa die Erkennung eines Krans in aufrechter Position nicht stimmig mit einer Transformation, bei der er eigentlich auf dem Kopf stehen müsste. Auf der anderen Seite gibt es zu einer einzigen Erkennung eines Merkmals 22 in einem Bild 3a-3c in der Regel mehrere mit dieser Erkennung stimmige Transformationen. Indem mehrere Gleichungen 51-53 in einem Gleichungssystem 5 zusammengeführt werden, werden solche Mehrdeutigkeiten aufgelöst, und der Einfluss von Fehlern bei der physikalischen Erfassung wird zurückgedrängt.

Figur 3 verdeutlicht anschaulich die Gewinnung (nicht erfindungsgemäß) von Gleichungen 54-56 anhand des Vergleichs 132 zwischen durch ein Positionierungssystem ermittelten Positionen 4a-4c des Mobilgeräts 1 einerseits und den sensorisch ermittelten Positionen 12a-12c, und/oder Orientierungen 13a-13c, andererseits. Die Positionen 4a-4c leben in diesem Beispiel in einem Weltkoordinatensystem 4, das in einer bekannten festen Relation 41 zum absoluten Koordinatensystem 21 der Baustelle 2 steht. In dem in Figur 3 gezeichneten Beispiel ist das absolute Koordinatensystem 21 der Baustelle 2 ein kartesisches Koordinatensystem, das an einem fixen, durch Längengrad und Breitengrad charakterisierten Punkt in Weltkoordinaten "aufgehängt" ist. Jeder Vergleich der Positionen in den verschiedenen Koordinatensystemen 4 und 11 liefert mindestens eine Gleichung 54-56, wobei sich die Weltkoordinaten 4 durch die bekannte Relation 41 in Koordinaten des absoluten Koordinatensystems 21 der Baustelle 2 ausdrücken lassen.

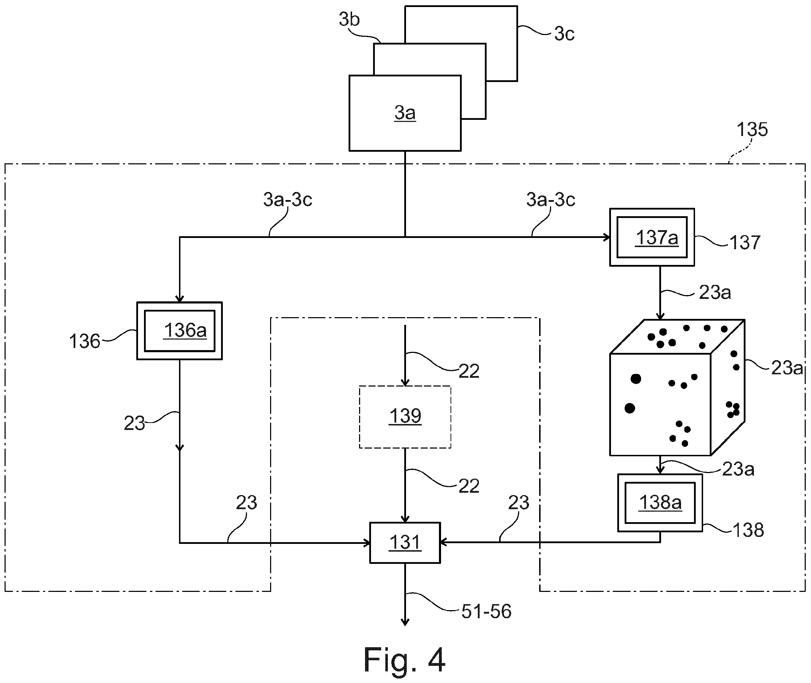

Figur 4 verdeutlicht verschiedene Möglichkeiten, wie aus mehreren Bildern 3a-3c gemäß Block 135 ein dreidimensionales Ist-Modell 23 der Baustelle 2 gewonnen werden kann.

Gemäß Block 136 können dreidimensionale Muster und Formen, und/oder zweidimensionale Projektionen hiervon, in den Bildern 3a-3c erkannt werden. Dann kann das Muster, bzw. die Form, direkt in ein dreidimensionales Ist-Modell 23 der Baustelle 2 eingesetzt werden. Dieses Ist-Modell bezieht sich auf das, was auf der Baustelle 2 zu sehen ist, lebt aber im internen Koordinatensystem 11 des Mobilgeräts 1, in dem die zugrundeliegenden Bilder 3a-3c leben

Gemäß Block 137 können die Pixel der Bilder 3a-3c zu einer Punktwolke 23a im dreidimensionalen Raum aggregiert werden, und zwar wiederum noch im internen Koordinatensystem 11 des Mobilgeräts 1. Das dreidimensionale Ist-Modell 23 der Baustelle 2 kann dann gemäß Block 138 erzeugt werden, indem dreidimensionale Muster bzw. Formen in dieser Punktwolke 23a erkannt werden. D.h., die Punktwolke liefert Anhaltspunkte dafür, welche Muster bzw. Formen wo im dreidimensionalen Raum einzusetzen sind, und die Muster bzw. Formen bilden dann gemeinsam das dreidimensionale Ist-Modell 23 der Baustelle 2, immer noch im internen Koordinatensystem 11.

Der Vergleich mit dem absoluten Koordinatensystem 21 der Baustelle 2 findet erst in Block 131 statt, wenn geometrische Merkmale 22 mit bekannten Positionen 22a im absoluten Koordinatensystem 21 der Baustelle 2 in dem dreidimensionalen Ist-Modell 23 erkannt werden. Hieraus werden Gleichungen 51-56 gewonnen.

Optional können für diesen Vergleich gemäß Block 139 diejenigen geometrischen Merkmale 22, die im Ist-Modell 23 zu erkennen sind, anhand der Farbinformationen von Pixeln in Bildern 3a-3c vorausgewählt werden.

Optional können gemäß den Blöcken 136a, 137a bzw. 138a Pixel, deren Farbinformationen ähnlich sind, als zum gleichen Muster, zur gleichen Form, bzw. zum gleichen Punkt im dreidimensionalen Raum, gehörig gewertet werden.

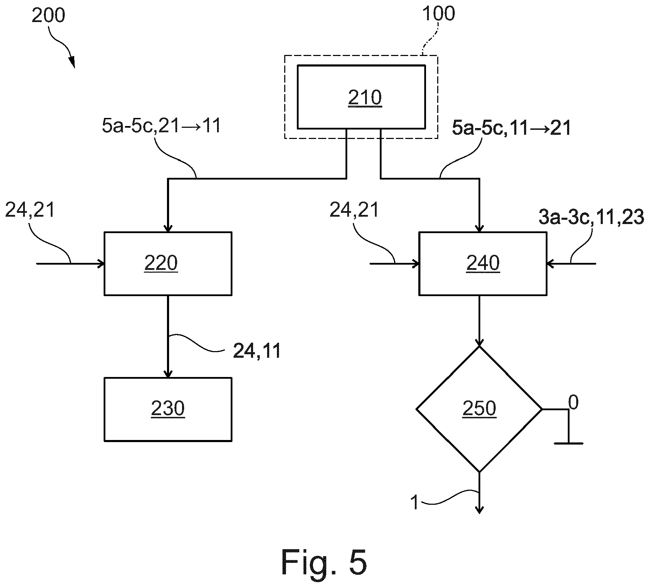

Figur 5 zeigt ein Ausführungsbeispiel des Verfahrens 200 zur computerunterstützten Qualitätskontrolle. In Schritt 210 wird mit dem zuvor beschriebenen Verfahren 100 das interne Koordinatensystem 11 des Mobilgeräts 1 auf das absolute Koordinatensystem 21 der Baustelle 2 kalibriert. Die dabei erhaltenen Lösungen 5a-5c des Gleichungssystems 5 charakterisieren sowohl eine Transformation vom internen Koordinatensystem 11 in das absolute Koordinatensystem 21 als auch eine umgekehrte Transformation vom absoluten Koordinatensystem 21 in das interne Koordinatensystem 11.

In Schritt 220 kann somit ein im absoluten Koordinatensystem 21 der Baustelle 2 erstelltes dreidimensionales Soll-Modell 24 in das interne Koordinatensystem 11 des Mobilgeräts 1 transformiert werden. In diesem internen Koordinatensystem 11 kann dann das Soll-Modell 24 in Schritt 230 einer aktuellen Ansicht der Baustelle 2 aus der Perspektive des Mobilgeräts 1 überlagert werden.

In Schritt 240 können die Bilder und/oder Scans 3a-3c, und/oder ein hieraus erstelltes dreidimensionales Ist-Modell 23 der Baustelle 2, aus dem internen Koordinatensystem 11 in das absolute Koordinatensystem 21 transformiert und dort mit dem Soll-Modell 24 der Schalung, bzw. des Gerüsts, verglichen werden. Anhand dieses Vergleichs kann in Schritt 250 geprüft werden, ob mindestens ein Bauelement und/oder Zubehörteil der Schalung, bzw. des Gerüsts, auf der Baustelle 2 korrekt verbaut worden ist.

### Bezugszeichenliste

- 1: Mobilgerät
- 11: internes Koordinatensystem des Mobilgeräts 1
- 12a-12c: Positionen des Mobilgeräts 1
- 13a-13c: Orientierungen des Mobilgeräts 1
- 2: Baustelle
- 21: absolutes Koordinatensystem der Baustelle 2
- 22, 22': geometrisches Merkmal
- 22a: Position des geometrischen Merkmals 22
- 23: dreidimensionales Ist-Modell der Baustelle 2
- 24: dreidimensionales Soll-Modell von Gerüst und/oder Schalung
- 3a-3c: Bilder oder Scans
- 4: Koordinatensystem des Positionierungssystems
- 41: Relation zwischen den Koordinatensystemen 4 und 21
- 4a-4c: Positionen, ermittelt in Koordinatensystem 4
- 5: Gleichungssystem
- 5a-5c: Unbekannte des Gleichungssystems 5
- 51-56: Gleichungen, bilden Gleichungssystem 5
- 100: Verfahren zur Kalibrierung der Koordinatensysteme 11 und 21
- 110: Aufnehmen von Bildern und/oder Scans 3a-3c
- 111: sensorisches Erfassen von Positionen 12a-12c, Orientierungen 13a-13c
- 120: Bestimmen von Positionen 4a-4c mit Positionierungssystem
- 121: sensorisches Erfassen von Positionen 12a-12c, Orientierungen 13a-13c
- 130: Aufstellen von Gleichungen 51-56
- 131: Erkennen geometrischer Merkmale 22 mit bekannten Positionen 22a
- 131a: Erkennen der Perspektive aus Verzerrungen im Bild/Scan 3a-3c
- 131b: Erkennen der Entfernungen aus der Größe im Bild/Scan 3a-3c
- 131c: Erkennen von Oberflächen und/oder Punkten
- 131d: Zuordnen von Oberflächen und/oder Punkten
- 131e: Anfordern einer Zuordnung von einem Bediener
- 132: Vergleichen von Positionen 4a-4c mit Sensormessung 12a-12c, 13a-13c
- 133: Gewichten der Gleichungen 51-57
- 135: Erstellen eines dreidimensionalen Ist-Modells 23
- 136: Erkennen der Projektionen von Formen und Mustern
- 136a: Berücksichtigung von Farbinformation
- 137: Aggregieren der Bilder/Scans 3a-3c zu einer Punktwolke 23a
- 137a: Berücksichtigung von Farbinformation
- 138: Erkennen von Formen und Mustern in der Punktwolke 23a
- 138a: Berücksichtigung von Farbinformation
- 139: Vorauswahl geometrischer Merkmale 22 nach Farbinformation
- 140: Lösen des Gleichungssystems 5 nach den Unbekannten 5a-5c
- 141: iteratives Vorgehen beim Lösen 140
- 200: Verfahren zur Qualitätskontrolle
- 210: Kalibrieren der Koordinatensysteme 11, 21 mit Verfahren 100
- 220: Transformieren des Soll-Modells 24 in das Koordinatensystem 11
- 230: Überlagern des Soll-Modells 24 mit aktueller Ansicht der Baustelle 2
- 240: Vergleichen des Soll-Modells mit Bildern/Scans 3a-3c, Ist-Modell 23
- 250: Prüfen auf korrekten Einbau von Bauelement/Zubehörteil

## Patentansprüche

1. Verfahren (100) zur Kalibrierung eines internen Koordinatensystems (11) eines Mobilgeräts (1) gegen ein absolutes Koordinatensystem (21) einer Baustelle (2) mit den Schritten:
• an einer Mehrzahl von Positionen auf der Baustelle (2), sowie optional zusätzlich mit einer Mehrzahl von Orientierungen des Mobilgeräts (1), wird jeweils mit dem Mobilgerät (1) mindestens ein Bild (3a-3c), das mindestens einen Teil der Baustelle (2) zeigt, aufgenommen (110);
• bei jeder Aufnahme (110) wird zusätzlich die Position (12a-12c) sowie optional zusätzlich die Orientierung (13a-13c) des Mobilgeräts (1) in dem internen Koordinatensystem (11) des Mobilgeräts (1) sensorisch erfasst (111, 121);
• es werden Gleichungen (51-56) aufgestellt (130) mit Unbekannten (5a-5c), die die gesuchte Transformation zwischen dem internen Koordinatensystem (11) des Mobilgeräts (1) und dem absoluten Koordinatensystem (21) der Baustelle (2) charakterisieren, wobei diese Gleichungen (51-56) erhalten werden, indem
• mindestens ein geometrisches Merkmal (22) mit bekannter Position (22a) im absoluten Koordinatensystem (21) der Baustelle (2) in einem Bild (3a-3c), und/oder in einem aus mehreren Bildern (3a-3c) ermittelten dreidimensionalen Ist-Modell (23) der Baustelle (2), erkannt wird (131);
• die Unbekannten (5a-5c) werden als Lösungen eines aus den aufgestellten Gleichungen (51-56) gebildeten Gleichungssystems (5) ermittelt (140).

2. Verfahren (100) nach Anspruch 1, wobei mindestens ein zwei- oder dreidimensionaler, auf der Baustelle (2) angebrachter Markierungscode als geometrisches Merkmal (22) gewählt wird.

3. Verfahren (100) nach einem der Ansprüche 1 bis 2, wobei mindestens ein Bauelement und/oder Zubehörteil als geometrisches Merkmal (22) gewählt wird.

4. Verfahren (100) nach einem der Ansprüche 1 bis 3, wobei das Erkennen (131) des geometrischen Merkmals (22) beinhaltet,
• aus der Verzerrung des geometrischen Merkmals (22) in dem Bild (3a-3c) eine Raumrichtung des Mobilgeräts (1) zu dem geometrischen Merkmal (22) zum Zeitpunkt der Aufnahme zu ermitteln (131a), und/oder
• aus der Größe des geometrischen Merkmals (22) in dem Bild (3a-3c) eine Entfernung des Mobilgeräts (1) zu dem geometrischen Merkmal (22) zum Zeitpunkt der Aufnahme zu ermitteln (131b).

5. Verfahren (100) nach einem der Ansprüche 1 bis 4, wobei den Gleichungen (51-56) in dem Gleichungssystem (5) in Abhängigkeit der Verlässlichkeit der in ihnen enthaltenen Informationen unterschiedliche Gewichte zugewiesen werden (133).

6. Verfahren (100) nach einem der Ansprüche 1 bis 5, wobei das Gleichungssystem (5) ausgehend von Startwerten, die aus a-priori-Informationen über die Baustelle (2) gewonnen wurden, iterativ gelöst wird (141).

7. Verfahren (100) nach einem der Ansprüche 1 bis 6, wobei das Erkennen (131) des geometrischen Merkmals (22) beinhaltet, mindestens eine Oberfläche, und/oder mindestens einen Punkt, in dem Bild (3a-3c) zu erkennen (131c) und mindestens einer Oberfläche, beziehungsweise mindestens einem Punkt, des geometrischen Merkmals (22) zuzuordnen (131d).

8. Verfahren (100) nach einem der Ansprüche 1 bis 7, wobei mindestens ein geometrisches Merkmal (22) gewählt wird, dessen Position (22a) im absoluten Koordinatensystem (21) der Baustelle (2) aus einem vorgegebenen dreidimensionalen Soll-Modell (24) der Baustelle (2), und/oder eines zu errichtenden oder zu ändernden Bauwerks, hervorgeht.

9. Verfahren (100) nach Anspruch 8, wobei mindestens eine Zuordnung eines im Bild (3a-3c) abgebildeten geometrischen Merkmals (22) zu einem in dem dreidimensionalen Soll-Modell (24) der Baustelle (2) enthaltenen geometrischen Merkmal (22') von einem Bediener angefordert wird (131e).

10. Verfahren (100) nach einem der Ansprüche 1 bis 9, wobei ein dreidimensionales Ist-Modell (23) der Baustelle (2) aus mehreren Bildern (3a-3c) erzeugt wird (135), indem dreidimensionale Muster und Formen, und/oder zweidimensionale Projektionen hiervon, in den Bildern (3a-3c) erkannt werden (136), und/oder die Pixel der Bilder (3a-3c) zu einer Punktwolke (23a) im dreidimensionalen Raum aggregiert werden (137) und die dreidimensionalen Muster bzw. Formen in dieser Punktwolke (23a) erkannt werden (138).

11. Verfahren (100) nach Anspruch 10, wobei Bildpixel, deren Farbinformationen ähnlich sind, als zum gleichen dreidimensionalen Muster, bzw. zur gleichen dreidimensionalen Form, und/oder zum gleichen Punkt im dreidimensionalen Raum, gehörig gewertet werden (136a, 137a, 138a).

12. Verfahren (100) nach einem der Ansprüche 1 bis 11, wobei geometrische Merkmale (22), die in dem dreidimensionalen Ist-Modell (23) erkannt werden (131), anhand der Farbinformationen der Pixel in Bildern (3a-3c) vorausgewählt werden (139).

13. Verfahren (200) zur computerunterstützten Qualitätskontrolle einer vorgegebenen Schalung, und/oder eines vorgegebenen Gerüsts, auf einer Baustelle (2) mit den Schritten:
• ein internes Koordinatensystem (11) eines Mobilgeräts (1) wird mit dem Verfahren (100) nach einem der Ansprüche 1 bis 12 auf ein absolutes Koordinatensystem (21) der Baustelle (2) kalibriert (210);
• ein im absoluten Koordinatensystem (21) der Baustelle (2) erstelltes dreidimensionales Soll-Modell (24) der Schalung, bzw. des Gerüsts, und/oder mindestens eine im absoluten Koordinatensystem (21) der Baustelle (2) erfasste räumlich aufgelöste Zustandsgröße der Schalung, bzw. des Gerüsts, wird in das interne Koordinatensystem (11) des Mobilgeräts (1) transformiert (220), und das Soll-Modell (24), und/oder die Zustandsgröße, der Schalung, bzw. des Gerüsts, wird einer aktuellen Ansicht der Baustelle (2) aus der Perspektive des Mobilgeräts (1) überlagert (230), und/oder
• anhand eines Vergleichs (240) zwischen dem Soll-Modell (24) der Schalung, bzw. des Gerüsts, einerseits und mindestens einem von dem Mobilgerät (1) aufgenommenen Bild und/oder Scan (3a-3c), und/oder mindestens einem aus mehreren solchen Bildern und/oder Scans (3a-3c) ermittelten Ist-Modell (23) der Baustelle (2), andererseits wird geprüft (250), ob mindestens ein Bauelement und/oder Zubehörteil der Schalung, bzw. des Gerüsts, auf der Baustelle (2) korrekt verbaut worden ist.

14. Computerprogramm, enthaltend maschinenlesbare Anweisungen, die, wenn sie auf mindestens einem Computer, und/oder auf mindestens einem Mobilgerät, ausgeführt werden, den Computer, bzw. das Mobilgerät, dazu veranlassen, jeweils die computerimplementierbaren Schritte eines Verfahrens (100, 200) nach einem der Ansprüche 1 bis 13 auszuführen.

15. Maschinenlesbarer Datenträger und/oder Downloadprodukt mit dem Computerprogramm nach Anspruch 14.

## Claims

1. Method (100) for calibrating an internal coordinate system (11) of a mobile device (1) against an absolute coordinate system (21) of a construction site (2), comprising the steps of:
at a plurality of positions on the construction site (2), and optionally additionally with a plurality of orientations of the mobile device (1), at least one image (3a-3c) showing at least part of the construction site (2) is recorded (110) in each case using the mobile device (1);
· for each reception (110), the position (12a-12c) and optionally additionally the orientation (13a-13c) of the mobile device (1) in the internal coordinate system (11) of the mobile device (1) are additionally detected by sensors (111, 121);
equations (51-56) are set up (130) with unknowns (5a-5c) which characterize the sought transformation between the internal coordinate system (11) of the mobile device (1) and the absolute coordinate system (21) of the construction site (2), wherein these equations (51-56) are obtained by
at least one geometric feature (22) with a known position (22a) in the absolute coordinate system (21) of the construction site (2) is detected (131) in an image (3a-3c) and/or in a three-dimensional actual model (23) of the construction site (2) determined from a plurality of images (3a-3c);
the unknowns (5a-5c) are determined (140) as solutions of a system of equations (5) formed from the established equations (51-56).

2. Method (100) according to claim 1, wherein at least one two- or three-dimensional marking code applied to the construction site (2) is selected as the geometric feature (22).

3. Method (100) according to any one of claims 1 to 2, wherein at least one component and/or accessory is selected as the geometric feature (22).

4. Method (100) according to any one of claims 1 to 3, wherein the recognition (131) of the geometric feature (22) involves
determining (131a) a spatial direction of the mobile device (1) to the geometric feature (22) at the time of reception from the distortion of the geometric feature (22) in the image (3a-3c), and/or
determining (131b) a distance of the mobile device (1) from the geometric feature (22) at the time of reception from the size of the geometric feature (22) in the image (3a-3c).

5. Method (100) according to any one of claims 1 to 4, wherein different weights are assigned (133) to the equations (51-56) in the system of equations (5) depending on the reliability of the information contained in them.

6. Method (100) according to any one of claims 1 to 5, wherein the system of equations (5) is solved iteratively (141) starting from initial values obtained from a priori information about the construction site (2).

7. Method (100) according to any one of claims 1 to 6, wherein the detection (131) of the geometric feature (22) involves detecting (131c) at least one surface and/or at least one point in the image (3a-3c) and assigning (131d) at least one surface or at least one point, respectively, to the geometric feature (22).

8. Method (100) according to any one of claims 1 to 7, wherein at least one geometric feature (22) is selected whose position (22a) in the absolute coordinate system (21) of the construction site (2) is derived from a predetermined three-dimensional nominal model (24) of the construction site (2) and/or of a structure to be erected or modified.

9. Method (100) according to claim 8, wherein at least one assignment of a geometric feature (22) depicted in the image (3a-3c) to a geometric feature (22') contained in the three-dimensional nominal model (24) of the construction site (2) is requested (131e) by an operator.

10. Method (100) according to any one of claims 1 to 9, wherein a three-dimensional actual model (23) of the construction site (2) is generated (135) from a plurality of images (3a-3c) by recognizing (136) three-dimensional patterns and shapes and/or two-dimensional projections thereof in the images ( 3a-3c) are recognized (136), and/or the pixels of the images (3a-3c) are aggregated (137) to form a point cloud (23a) in three-dimensional space and the three-dimensional patterns or shapes in this point cloud (23a) are recognized (138).

11. Method (100) according to claim 10, wherein image pixels whose color information is similar are evaluated (136a, 137a, 138a) as belonging to the same three-dimensional pattern or the same three-dimensional shape and/or to the same point in three-dimensional space.

12. Method (100) according to any one of claims 1 to 11, wherein geometric features (22) which are recognized (131) in the three-dimensional actual model (23) are preselected (139) on the basis of the color information of the pixels in images (3a-3c).

13. Method (200) for computer-aided quality control of a predetermined formwork and/or a predetermined scaffold at a construction site (2) comprising the steps of:
an internal coordinate system (11) of a mobile device (1) is calibrated (210) with the method (100) according to any one of claims 1 to 12 to an absolute coordinate system (21) of the construction site (2);
a three-dimensional nominal model (24) of the formwork and/or scaffold constructed in the absolute coordinate system (21) of the construction site (2), and/or at least one spatially resolved state variable of the formwork and/or scaffold recorded in the absolute coordinate system (21) of the construction site (2) is transformed (220) into the internal coordinate system (11) of the mobile device (1), and the nominal model (24) and/or the state variable of the formwork or scaffold is overlaid (230) on a current view of the construction site (2) from the perspective of the mobile device (1), and/or
on the basis of a comparison (240) between the nominal model (24) of the formwork or the scaffold, on the one hand, and at least one image and/or scan (3a-3c) taken by the mobile device (1) and/or at least one actual model (23) of the construction site (2) determined from a plurality of such images and/or /or scans (3a-3c) (23) of the construction site (2), on the other hand, it is checked (250) whether at least one component and/or accessory of the formwork or the scaffold has been correctly installed on the construction site (2).

14. Computer program containing machine-readable instructions that, when executed on at least one computer and/or on at least one mobile device, cause the computer or the mobile device, respectively, to execute the computer-implementable steps of a method (100, 200) according to any one of claims 1 to 13.

15. Machine-readable data carrier and/or download product with the computer program according to claim 14.

## Revendications

1. Procédé (100) d'étalonnage d'un système de coordonnées interne (11) d'un appareil mobile (1) par rapport à un système de coordonnées absolu (21) d'un chantier (2), comprenant les étapes consistant à :
• prendre (110) au moins une image respective (3a-3c) au moyen de l'appareil mobile (1), laquelle montre au moins une partie du chantier (2), à une pluralité de positions sur le chantier (2) et, en option, avec une pluralité d'orientations de l'appareil mobile (1),
• lors de chaque prise de vue (110), détecter (11, 121) au moyen de capteurs en supplément la position (12a-12c) et, en option, en supplément l'orientation (13a-13c) de l'appareil mobile (1) dans le système de coordonnées interne (11) de l'appareil mobile (1) ;
• établir (130) des équations (51-56) à inconnues (5a-5c), caractérisant la transformation recherchée entre le système de coordonnées interne (11) de l'appareil mobile (1) et le système de coordonnées absolu (21) du chantier (2), ces équations (51-56) étant obtenues en
• reconnaissant (131) dans une image (3a-3c) et/ou dans un modèle réel tridimensionnel (23) du chantier (2), déterminé à partir de plusieurs images (3a-3c), au moins une caractéristique géométrique (22) ayant une position connue (22a) dans le système de coordonnées absolu (21) du chantier (2) ;
• déterminer (140) les inconnues (5a-5c) en tant que solutions d'un système d'équations (5) formé à partir des équations établies (51-56).

2. Procédé (100) selon la revendication 1,
dans lequel au moins un code de marquage bidimensionnel ou tridimensionnel apposé sur le chantier (2) est choisi comme caractéristique géométrique (22).

3. Procédé (100) selon l'une des revendications 1 à 2,
dans lequel au moins un élément de construction et/ou un accessoire est choisi comme caractéristique géométrique (22).

4. Procédé (100) selon l'une des revendications 1 à 3,
dans lequel la reconnaissance (131) de la caractéristique géométrique (22) consiste à
• déterminer (131a), à partir de la distorsion de la caractéristique géométrique (22) dans l'image (3a-3c), une direction spatiale de l'appareil mobile (1) par rapport à la caractéristique géométrique (22) au moment de la prise de vue, et/ou
• déterminer (131b), à partir de la taille de la caractéristique géométrique (22) dans l'image (3a-3c), une distance entre l'appareil mobile (1) et la caractéristique géométrique (22) au moment de la prise de vue.

5. Procédé (100) selon l'une des revendications 1 à 4,
dans lequel des poids différents sont attribués (133) aux équations (51-56) dans le système d'équations (5), en fonction de la fiabilité des informations qu'elles contiennent.

6. Procédé (100) selon l'une des revendications 1 à 5,
dans lequel le système d'équations (5) est résolu (141) de manière itérative à partir de valeurs de départ obtenues à partir d'informations a priori relatives au chantier (2).

7. Procédé (100) selon l'une des revendications 1 à 6,
dans lequel la reconnaissance (131) de la caractéristique géométrique (22) implique de reconnaître (131c) au moins une surface et/ou au moins un point dans l'image (3a-3c) et de l'associer (131d) à au moins une surface ou à au moins un point de la caractéristique géométrique (22).

8. Procédé (100) selon l'une des revendications 1 à 7,
dans lequel on choisit au moins une caractéristique géométrique (22) dont la position (22a) dans le système de coordonnées absolu (21) du chantier (2) ressort d'un modèle tridimensionnel de consigne (24) du chantier (2) et/ou d'un ouvrage à construire ou à modifier.

9. Procédé (100) selon la revendication 8,
dans lequel au moins une association d'une caractéristique géométrique (22), représentée dans l'image (3a-3c), à une caractéristique géométrique (22') contenue dans le modèle tridimensionnel de consigne (24) du chantier (2) est demandée (131e) par un opérateur.

10. Procédé (100) selon l'une des revendications 1 à 9,
dans lequel on génère (135) un modèle tridimensionnel réel (23) du chantier (2) à partir d'une pluralité d'images (3a-3c) en reconnaissant (136) dans les images (3a-3c) des motifs et des formes tridimensionnels et/ou des projections bidimensionnelles de ceux-ci, et/ou en agrégant (137) les pixels des images (3a-3c) en un nuage de points (23a) dans l'espace tridimensionnel et en reconnaissant (138) les motifs ou les formes tridimensionnels dans ce nuage de points (23a).

11. Procédé (100) selon la revendication 10,
dans lequel des pixels d'image, dont les informations chromatiques sont similaires, sont considérés (136a, 137a, 138a) comme appartenant au même motif tridimensionnel ou à la même forme tridimensionnelle et/ou au même point dans l'espace tridimensionnel.

12. Procédé (100) selon l'une des revendications 1 à 11,
dans lequel des caractéristiques géométriques (22) reconnues (131) dans le modèle tridimensionnel réel (23) sont présélectionnées (139) à l'aide des informations chromatiques des pixels dans des images (3a-3c).

13. Procédé (200) de contrôle de qualité assisté par ordinateur d'un coffrage donné et/ou d'un échafaudage donné sur un chantier (2), comprenant les étapes consistant à :
• étalonner (210) un système de coordonnées interne (11) d'un appareil mobile (1) sur un système de coordonnées absolu (21) du chantier (2) par le procédé (100) selon l'une des revendications 1 à 12 ;
• transformer (220) vers le système de coordonnées interne (11) de l'appareil mobile (1) un modèle tridimensionnel de consigne (24) du coffrage ou de l'échafaudage, créé dans le système de coordonnées absolu (21) du chantier (2), et/ou au moins une grandeur d'état du coffrage ou de l'échafaudage, résolue dans l'espace et saisie dans le système de coordonnées absolu (21) du chantier (2), et superposer (230) le modèle de consigne (24) et/ou la grandeur d'état du coffrage ou de l'échafaudage à une vue actuelle du chantier (2) depuis la perspective de l'appareil mobile (1), et/ou
• à l'aide d'une comparaison (240) entre le modèle de consigne (24) du coffrage ou de l'échafaudage, d'une part, et au moins une image et/ou un scan (3a-3c) pris par l'appareil mobile (1) et/ou au moins un modèle réel (23) du chantier (2) déterminé à partir de plusieurs telles images et/ou scans (3a-3c), d'autre part, vérifier (250) si au moins un élément de construction et/ou un accessoire du coffrage ou de l'échafaudage, a été correctement mis en place sur le chantier (2).

14. Programme informatique contenant des instructions lisibles par machine qui, lorsqu'elles sont exécutées sur au moins un ordinateur et/ou sur au moins un appareil mobile, amènent l'ordinateur ou l'appareil mobile à exécuter les étapes respectives, exécutables par ordinateur, d'un procédé (100, 200) selon l'une des revendications 1 à 13.

15. Support de données lisible par machine et/ou produit à télécharger comprenant le programme informatique selon la revendication 14.
